# EUROPEAN PATENT APPLICATION

(11) **EP 3 993 264 A1**
(43) Date of publication of application: **04.05.2022**
(21) Application number: 20204268.5
(22) Date of filing: 28.10.2020
(51) Int. Cl.: H03K 17/082, H02M 1/32, H02M 1/36, H02M 3/158, H02M 3/335, H03K 17/10, H03K 17/16, H03K 17/687

(54) **SWITCH CONTROLLER, DEVICE AND METHOD WITH OVERCURRENT PROTECTION**

(71) Applicant: Infineon Technologies Austria AG, 9500 Villach (AT)
(72) Inventor: TEO, Yong Siang, 797501 Singapore (SG); MALININ, Andrey, 80525, Fort Collins (US)
(74) Representative: Sticht, Andreas

(57) **Abstract**

Switch controllers, devices including such switch controllers and methods are provided. When switching on a switch device (11, 12), for a predefined time the switch device is set to a first impedance, and after the predefined time the switch device is set to a second impedance lower than the first impedance.

## Description

### TECHNICAL FIELD

The present application relates to switch controllers related to an overcurrent protection for a switch device, devices including such switches and switch controllers, for example power converters like flyback converters, and to corresponding methods.

### BACKGROUND

Power converter are used to convert an input electrical power to an output electrical power for supplying some device with power. Examples for power converters include voltage converters like AC/AC converters, AC/DC converters or DC/DC converters, or current converters converting a first current to a second current. One type of power converters are flyback converters.

In flyback converters, as well as some other types of converters, one or more primary side switch devices are operated to supply a secondary side of the power converter with a desired amount of power. Such converters are also sometimes referred to as switched mode power supplies (SMPS). For example, in flyback converters, a switch is operated to selectively provide power to a primary winding of a transformer, and an output voltage is tapped on a secondary side of the converter coupled to a secondary winding of the transformer. The switching and thus the amount of power supplied may for example depend on a feedback from an output of the power converter.

Switch devices as the ones mentioned above are often implemented using transistors, in this context often referred to as power transistors, as they need to switch high voltages (for example above 10 V, above 50 V, or even some hundreds V) and/or high currents (for example of the order of 1 A or above). Examples for such transistors include MOSFET transistors, insulated gate bipolar transistors (IGBTs) or bipolar junction transistors (BJTs).

Such power converters need to be protected against various faults. One type of faults that may occur are overcurrents, where a current through the switch device exceeds a current the switch device was designed for. In a flyback converter, such an overcurrent may happen due to various reasons. For example, the primary side transformer winding may be shortcircuited, for example due to solder or some foreign object short-circuiting the winding. Also, a shoot-through may occur when a switch of a synchronous rectifier on a secondary side is switched on at the same time as the primary switch supplying the primary side winding of the transformer with power.

Various approaches are known for overcurrent protection. Some of these involve measuring a current through the primary side switch and setting the switch device to "off" when the current exceeds a threshold. Current measurements may for example be done using sense resistors, replica transistors or the like.

One problem with this kind of overcurrent protection is that in some implementations of switch devices, for example using MOSFETs, a current spike, for example due to discharging of a drain source capacitance, may occur when switching the switch device on. Such a current spike is also dependent on an input current of the power converter. It may be difficult to distinguish such a current spike which occurs in normal operation from a real overcurrent situation where the current becomes too high due to some fault.

Some overcurrent protection schemes use system level approaches. For this approach, a controller of the power converter uses the information about the current through the switch device by measuring it for example using a shunt resistor or the like to detect a fault event. In some of such approaches, a counter may be used such that a fault condition is only detected if it persists over a predefined number of clock cycles.

Such system level protection is relatively complex and slow. Furthermore, it is difficult to implement for the above mentioned initial current spikes when switching the switch device on.

Other approaches use an overcurrent protection built in to the driver of the primary switch device, for example by detecting a drain source voltage drop in case of a field effect transistor during a time when a gate voltage is high. When the drain source voltage does not drop under a predefined threshold within a predefined time after the rising edge of a control signal turning on the switch device, a fault condition is determined. Also in this approach, there may be a mistriggering of the protection when turning on the switch device due to the above voltage spike, and furthermore, in case of field effect transistors, a diode is used which has to be used which is difficult to integrate into a driver integrated circuit and therefore has to be provided as a separate component which is not desirable. To avoid such mistriggering, a blanking time where the overcurrent protection is inactive may be used, but in this case overcurrent conditions during the blanking time may adversely affect the switch device.

### SUMMARY

A controller as defined in claim 1, a device as defined in claim 10 and a method as defined in claim 12 are provided. The dependent claims define further embodiments.

According to an embodiment, a switch controller is provided, comprising:
a driver configured to drive a power switch device and a second switch device coupled in series to the power switch, wherein the driver is configured to, when switching the power switch device on, to set the second switch device to a first on-resistance for a predefined time starting from switching on the power switch device, and after the predefined time, set the second switch device to a second on-resistance lower than the first on-resistance.

According to another embodiment, a device is provided, comprising such a controller and the switch device.

According to a further embodiment, a method is provided, comprising:
switching on a power switch device; and
controlling a second switch device coupled in series to the power switch device to have a first on-resistance for a predefined time after switching on the power switch device, and to have a second on-resistance lower than the first on-resistance after the predefined time.

The above summary is merely intended to give a brief overview over some embodiments and is not to be construed as limiting in any way.

### BRIEF DESCRIPTION OF THE DRAWINGS

Fig. 1 is a block diagram of a device according to an embodiment.
Fig. 2 is a circuit diagram illustrating a device according to an embodiment.
Fig. 3 is a circuit diagram illustrating a device according to an embodiment.
Fig. 4 is a flow chart illustrating a method according to some embodiments.
Figs. 5A to 5C show schematic signals in an embodiment during normal operation.
Figs. 6A to 6C show schematic signals in an embodiment when a fault condition occurs.
Fig. 7 is a diagram for illustrating a safe operating area of a transistor.
Fig. 8 is a diagram illustrating a multilevel driver usable in some embodiments.
Fig. 9 is a diagram illustrating an alternative to the multilevel driver of Fig. 8, usable in some embodiments.
Fig. 10 is a diagram illustrating an overcurrent detection circuit usable in some embodiments.

### DETAILED DESCRIPTION

In the following, various embodiments will be described referring to the attached drawings. These embodiments are given by way of example only and are not to be construed as limiting in any way. For example, while embodiments may be described as including various features (for example components, elements, method acts or events etc.), in other embodiments some of these features may be omitted or may be replaced by alternative features. In addition to the features explicitly shown and described herein other features, for example features used in conventional switch controllers or power converters may be provided.

Features from different embodiments may be combined unless noted otherwise. Variations, modifications or details described with respect to one of the embodiments may also be applied to other embodiments and will therefore not be described repeatedly.

Connections or couplings described herein or shown in the drawings refer to electrical connections or couplings unless noted otherwise. Such electrical connections or couplings may be modified for example by providing additional intervening elements or my removing elements, as long as the general purpose of the connection or coupling, for example to provide a voltage or to provide a signal like a control signal or the like is essentially maintained. In other words, connections or couplings may be modified as long as their function is essentially preserved.

Some embodiments described herein use switch devices. A switch device, as used herein, is a device to selectively provide an electrical connection between its load terminals. A switch device is described as switched on, turned on, on or closed when there is an electrical connection between the load terminals over which significant current may flow. A resistance is this state is referred to as on-resistance. In some switch devices, the on-resistance may be varied between different levels. A switch device is described as being switched off, turned off, off or open when it provides essentially an electric isolation between its load terminals (apart from possibly very small leakage currents which may occur in real devices).

The state of a switch device (on or off) may be controlled via a control terminal. A switch device may comprise several (sub) switch devices connected in parallel and/or in series.

Switch devices may be implemented using one or more transistors, for example field effect transistors (FETs) like metal oxide semiconductor field effect transistors (MOSFETs), bipolar junction transistors (BJTs) or insulated-gate bipolar transistors (IGBTs). A switch device may include one transistor, In case of a field effect transistor, the load terminals correspond to the drain and source terminals, and the control terminal corresponds to the gate terminal. In case of a bipolar junction transistor, the load terminals correspond to the collector and emitter terminals and the control terminal corresponds to the base terminal. In case of an insulated-gate bipolar transistor, the load terminals correspond to the collector and emitter terminals and the control terminal corresponds to the gate terminal. While in some embodiments discussed below, MOSFETs will be used as an example, it is to be understood that similar embodiments may be implemented using other types of transistors or mixtures of different types of transistors. Also, a switch represented as a transistor may include a plurality of transistor cells coupled e.g. in parallel or in series, which may be used to provide power transistors enabling a switching of high voltages or high currents.

In embodiments discussed below, power converters, for example flyback converters, are used as application examples. However, techniques discussed herein may also be used in other applications where an overcurrent condition is to be detected and monitored, in particular applications, in which upon switching on a transistor used as a switch device, a currents spike may occur.

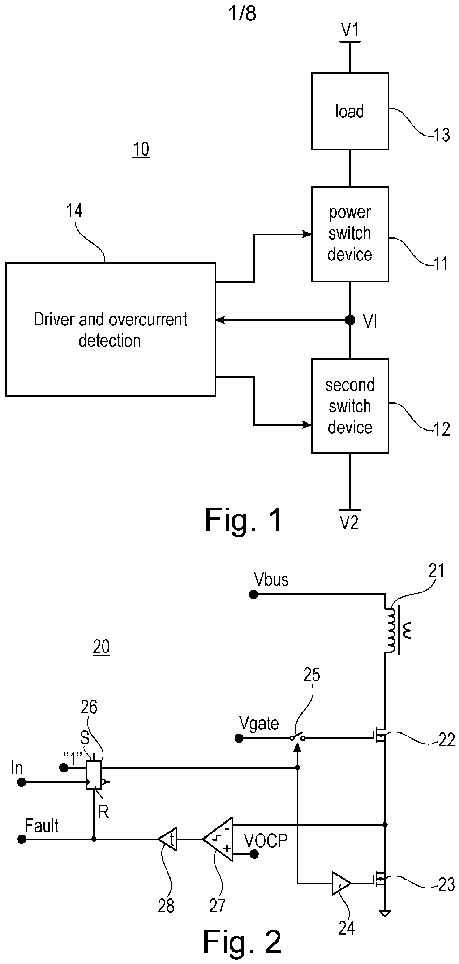

Turning now to the figures, Fig. 1 is a block diagram of a device 10 according to an embodiment.

Device 10 comprises a power switch device 11, controlled by a driver and overcurrent detection circuit 14. Driver and overcurrent detection circuit 14 may also be referred to as controller herein. Power switch device 11 is coupled in series with a load 13 between a first voltage VI, for example a positive supply voltage like Vdd, and a second voltage V2 for example Vss are ground. In case of a flyback converter, load 13 may for example be a primary winding of a transformer.

Power switch device 11 is controlled by driver and overcurrent detection circuit 14 to selectively provide power to load 13, for example the primary winding of the flyback converter.

Furthermore, a second switch device 12 is coupled between power switch device 11 and second voltage V2 as shown in Fig. 1.

Second switch device 12 has a first switched-on state and a second switched-on state. This does not preclude that the second switch device has further switched-on states like a third switched-on state, a fourth switched-on state etc. In some embodiments, second switch device 12 is switched synchronously with power switch device 11, such that when power switch device 11 is switched on, second switch device 12 is also switched on.

In embodiments, the first switched-on state has a higher on-resistance than the second switched-on state. For example, the on-resistance in the first switched-on state may be between 2 and 20 Ω, for example between 5 and 15 Ω, for example about 10 Ω, whereas in the second switched-on state, the on-resistance may for example be below 1 Ω or below 0.5 Ω; for example about 0.2 Ω. As will be explained below, such different on-resistances may for example be generated by applying different gate voltages to a transistor, or by using different transistors with different on-resistance parallel.

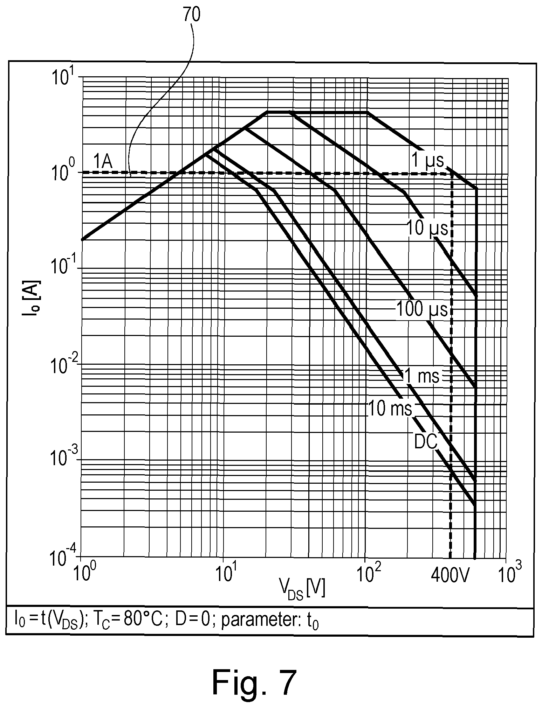

When power switch device 11 is switched on, for a predefined time second switch device 12 is set to the first switched-on state, followed by the second switched-on state. The predefined time is also referred to a leading edge blanking time (LEB) herein and may be of the order of 100 to 500 ns, for example about 200 ns, but is not limited thereto and may be selected depending on the application and properties of power switch device 11. For example, as will be discussed further below with reference to Fig. 7, the duration of the LEB may be selected based on a safe operating area of the power switch device, for example a maximum allowed current. In particular, the leading edge blanking time may be selected such that a current caused by discharging of a drain source capacitance or other internal capacitances of power switch device 11 when switching power switch device 11 on occurs within this leading edge blanking time. In this case, as second switch device 12 has a higher on-resistance in the leading edge blanking time, the current of such a current spike is limited. It should be noted that when power switch device 11 is turned fully on with a low on-resistance, the on-resistance of the series connection of switch devices, 11, 12 may be mainly determined by second switch device 12. In other embodiments, second switch device 12 may be always switched on, either with a first on-resistance during the leading edge blanking time or with the second on-resistance otherwise.

Furthermore, as will be explained below, a fault condition may be detected by monitoring a voltage VI between the power switch device 11 and the second switch device 12 at least during the leading edge blanking time. For example, if load 13 is in good condition, parasitic capacitances of power switch device 11 will be discharged quickly, and the voltage VI will drop. If the voltage VI exceeds a threshold voltage after switching on power switch device 11 this may indicate a fault condition like a short circuit in load 13. The load being in good condition means that an impedance of a load (e.g. resistance or inductor) is within predefined specifications, so in case of a resistive load it is limiting the current through the load, and/or in case of an inductive load it is limiting the rate dI/dt a current I may increase during time t.

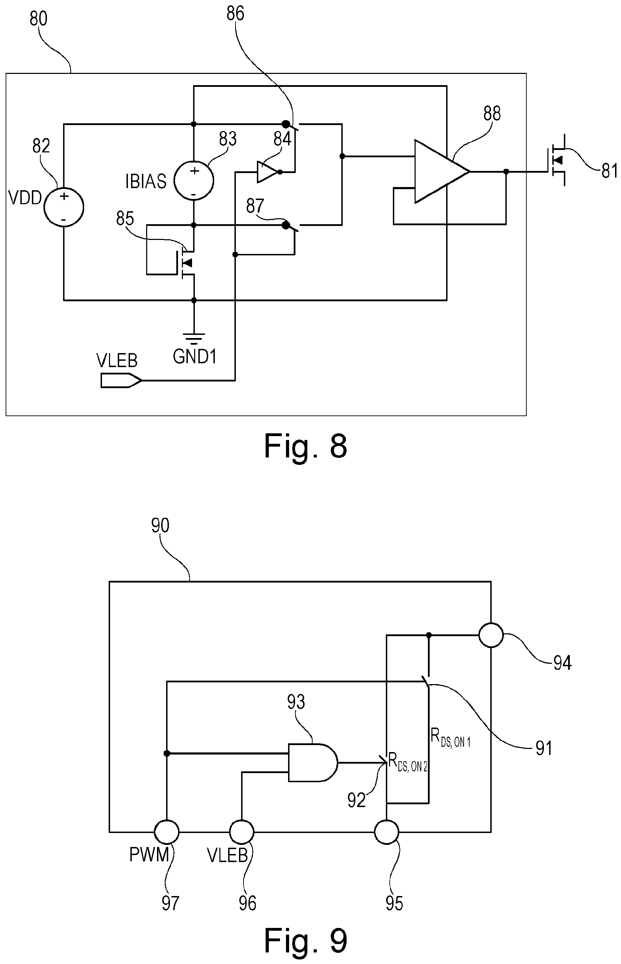

While power switch device 11 and second switch device 12 are coupled in series in Fig. 1, in other embodiments also two switch devices may be coupled in parallel to provide different on-resistances in a part from a load to a voltage like V2, as will be explained further below with reference to Fig. 9.

Implementation examples for the above features and techniques, in particular the use of two different switched-on states and the fault detection based on voltage VI, will now be further explained referring to Figs. 2 to 10.

Fig. 2 shows a circuit diagram illustrating a device according to an embodiment. Device 20 of Fig. 2 comprises a primary winding of a transformer 21, a power transistor 22 and a further transistor, referred to as a source transistor 23 as it is positioned on a source side of power transistor 22, coupled in series between the voltage Vbus and the ground. Power transistor 22 and source transistor 23 are therefore arranged in cascode configuration.

Power transistor 22 and source transistor 23 in the example of Fig. 2 are MOSFET transistors, but are not limited thereto. Transformer 21 may be a transformer of a power converter like a flyback converter. Primary winding of transformer 21 is an example for load 13 of Fig. 1, power transistor 22 is an example for power switch device 11 of Fig. 1, and source transistor 23 is an example for second switch device 12 of Fig. 1.

Via a switch 25, a gate voltage Vgate may be applied to power transistor 22 controlled by a logic circuit 26. Switch 25 may be implemented as a transistor. Logic circuit 26 in the example shown includes a flip-flop. In operation, a signal IN is provided to logic circuit 26, which in case of a power converter may for example be a pulse width modulated (PWM) signal such that in normal operation (absent a fault condition which will be discussed below), according to the PWM signal a logic 1 is selectively provided to switch 25 closing switch 25 and thus applying the gate voltage Vgate to power transistor 22 according to the PWM signal. In this way, power may selectively be supplied to the primary winding of transformer 21, thus operating for example a power converter like a flyback converter.

Furthermore, the output of logic circuit 26 which is provided to control switch 25 is also provided to a multi-level driver 24 controlling source transistor 23. Multi-level driver 24 may be configured to apply a first gate voltage to source transistor 23 during a predefined leading edge blanking time when the signal output by logic 26 transitions to a logic 1 indicating that switch 25 is to be closed, and provide a second gate voltage to source transistor 23 after the leading edge blanking time, until the output from logic circuit 26 transitions to 0 indicating an opening of switch 25. When switch 25 is open, power transistor 22 is switched off, and in some embodiments also source transistor 23 is switched off by multi-level gate driver 24.

The first gate voltage may cause source transistor 23 to have a higher on-resistance, as explained also for second switch device 12 with respect to Fig. 1, and the second gate voltage may be a higher gate voltage causing source transistor 23 to have a lower on-resistance. Ranges for on-resistances may be the same as explained for second switch device 12 of Fig. 1, for example above 2 Q for the first gate voltage and below 1 Q for the second gate voltage.

Possible values for the leading edge blanking time may be the same as discussed above with respect to Fig. 1.

In this way, due to the higher on-resistance of source transistor 23 during the leading at blanking time, the current is limited even when the current spike occurs due to discharging of a drain source capacitance of power switch 22.

Furthermore, a fault condition in device 20 is monitored by monitoring a voltage at a node between power transistor 22 and source transistor 23, corresponding to voltage Vi of Fig. 1. The node between transistors 22, 23 is coupled to a first input (negative input in the example of Fig. 2) and output comparator 27 is provided to a timer 28. Using comparator 27 and timer 28, device 20 measures if the voltage at the node between transistors 22, 23 falls quickly corresponding to a quick discharge of the drain source capacitance or other parasitic capacitances of power transistor 22. If this is the case, no fault condition is detected. Else, if the voltage does not drop fast enough and/or exceeds a threshold even after a predefined time has passed, logic circuit 26 is reset such to switch switch 25 off and therefore switching power switch 22 off. Furthermore, a signal fault indicating the fault state is output by device 20 in this case.

The signal fault may then be processed by other entities, for example to inform a user of the fault condition.

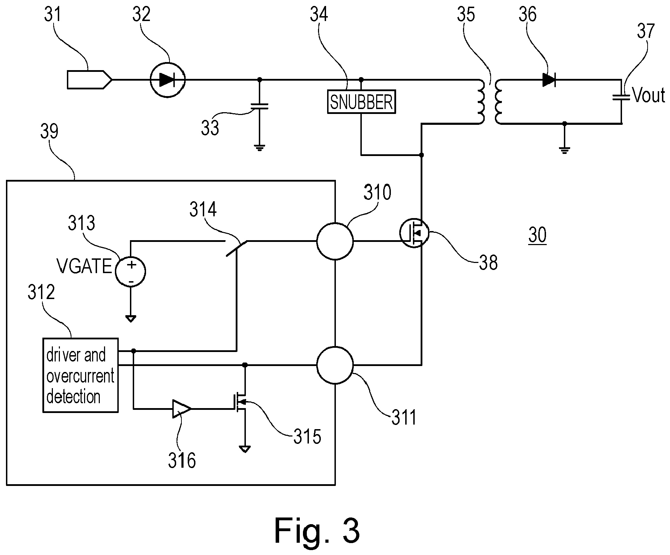

Fig. 3 illustrates a device 30 according to a further embodiment. Device 30 is a flyback converter and therefore is an application example for techniques discussed herein.

Device 30 receives an AC input voltage 30 at an input 31. A rectifier 32 rectifies the AC input voltage, which is buffered by a bulk capacitor 33.

A snubber circuit 34, which may be implemented in any conventional manner, may improve the signal quality of the rectified input signal.

The voltage thus generated may for example correspond to the voltage Vbus in Fig. 2 or V1 in Fig. 1.

This voltage is provided to a series connection of a primary winding of a transformer 35, a power transistor 38 and a source transistor 315. Source transistor 315 is arranged in a controller 39 and coupled to a source terminal of power transistor 38 via a terminal 311 (for example a pin, solder pad or the like) of controller 39. Controller 39 may for example be implemented on a separate chip and provided in a separate package in some embodiments. In other embodiments, source transistor 315 may be provided external to controller 39.

A secondary winding of transformer 35 is coupled to an output capacitor 37 via a rectifying diode 36 as shown. An output voltage of the power converter Vout may be tapped at output capacitor 37.

A gate terminal of power transistor 38 is coupled to a terminal 310 (for example a pin, solder pad or the like) of controller 39 to selectively be supplied by a gate voltage Vgate from a voltage source 313 via a switch 314. Switch 314 may for example be implemented as a transistor switch. Switch 314 is controlled by a driver and overcurrent detection circuit 312 of controller 39, for example based on a pulse width modulated control signal as in conventional power controllers. This pulse width modulated control signal may for example be based on a feedback indicative of the voltage Vout to controller 39, as in conventional power converters and controllers.

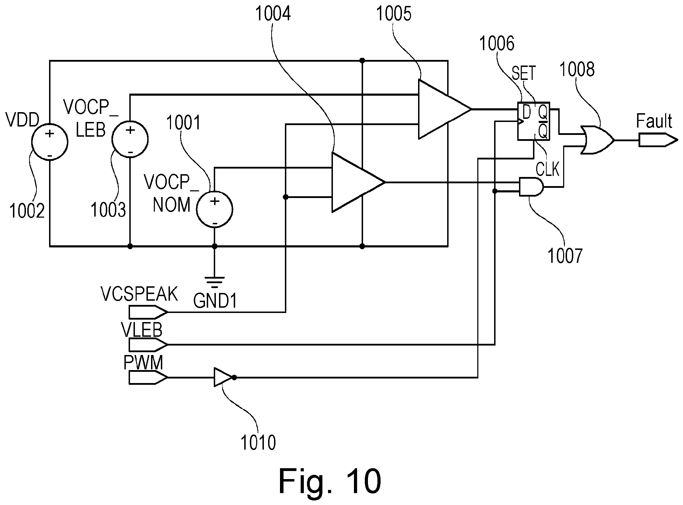

Furthermore, source transistor 315 is controlled via a multilevel driver 316 by the same control signal from driver and overcurrent detection circuit 312 as switch 314. The functioning is similar to the functioning of switch 25 and multilevel driver 24 explained with respect to Fig. 2, i.e. when power transistor 38 is switched on, also source transistor 315 is switched on. Furthermore, during a predefined leading edge blanking time, source transistor 315 is switched on with a first on-resistance which is higher than a second on-resistance after the leading edge blanking time. Furthermore, driver and overcurrent detection circuit 312 receives a voltage at a node between source transistor 315 and terminal 311, corresponding to the voltage Vi of Fig. 1 and the corresponding voltage of Fig. 2, to detect a fault condition like an overcurrent condition, for example using elements like comparator 27 and timer 28 of Fig. 2 or a detection scheme as discussed further below referring to Fig. 10.

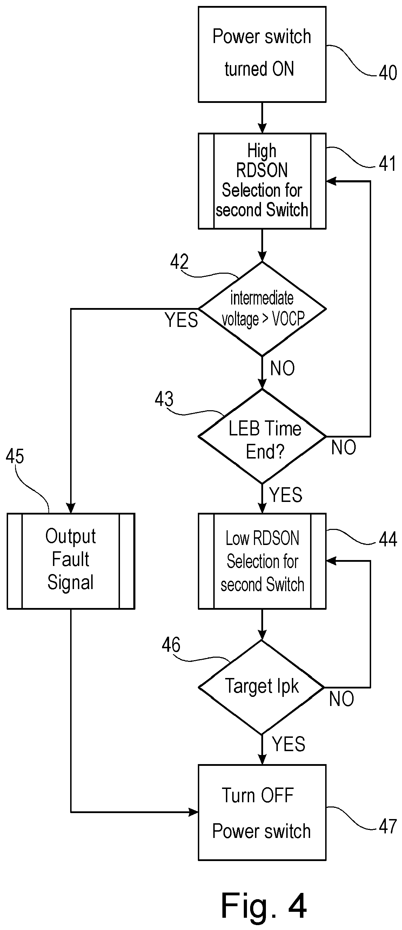

Fig. 4 is a flowchart illustrating a method according to some embodiments. The method of Fig. 4 may be implemented using the devices discussed with reference to Figs. 1 to 3 above, and to avoid repetitions will be described referring to the previous explanations. However, it is to be understood that the method of Fig. 4 may also be implemented in other embodiments than those of Figs. 1 to 3.

At 40, the method of Fig. 4 comprises switching on a power switch device like power transistor 22 or 38, to switch the power transistor, for example by applying a corresponding gate voltage. In some embodiments, essentially at the same time, at 41, the method comprises switching on a source transistor like source transistor 23 or 315, which is coupled in series to a power transistor, with a first on-resistance, which is higher on-resistance than a second on-resistance used later, as already explained above with reference to Figs. 1 to 3.

At 42, the method comprises checking if a voltage between the power transistor and the source transistor, as shown in Fig. 3 may be present at terminal 311, is greater than a threshold voltage after a predefined time. If this is the case, as explained this indicates a fault condition, and at 35 the method comprises outputting a fault signal. The method then continues at 47, where the power switch device is switched off, for example by changing the gate voltage accordingly.

The high on-resistance selected at 41 and the monitoring of the intermediate voltage at 42 are maintained until a predefined leading edge blanking time, which may be as explained above, for example of the order of 200 ns, ends. Then, after the leading edge blanking time, at 44 the on-resistance of the second switch is set to a second, lower on-resistance, for example below 1 Q as explained above. This condition is maintained until a predefined criterion for switching off the power switch is reached. The criterion may depend on the regulation implemented, for example regulation of a power converter. For example, in some implementations the condition with the second switch at the lower on-resistance may be maintained, until a predefined target peak current Ipk through the power switch device is reached. Then, at 47, the power switch device is switched off. The method may then be repeated in a next switching cycle.

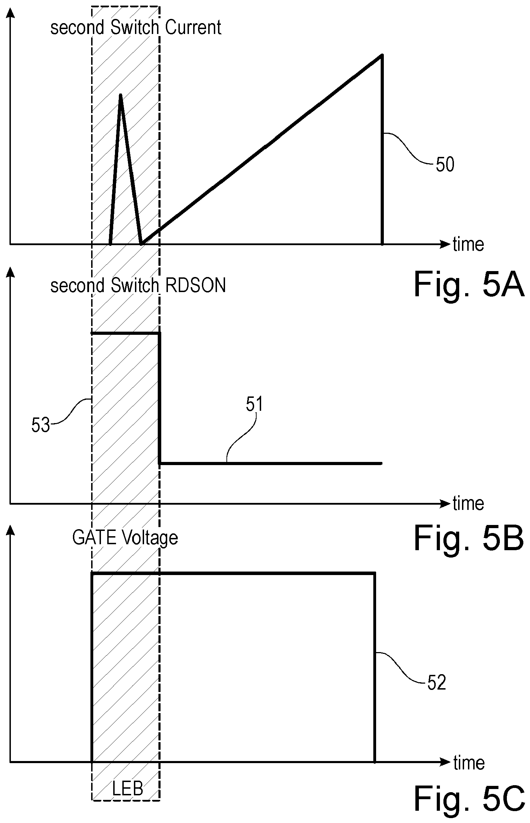

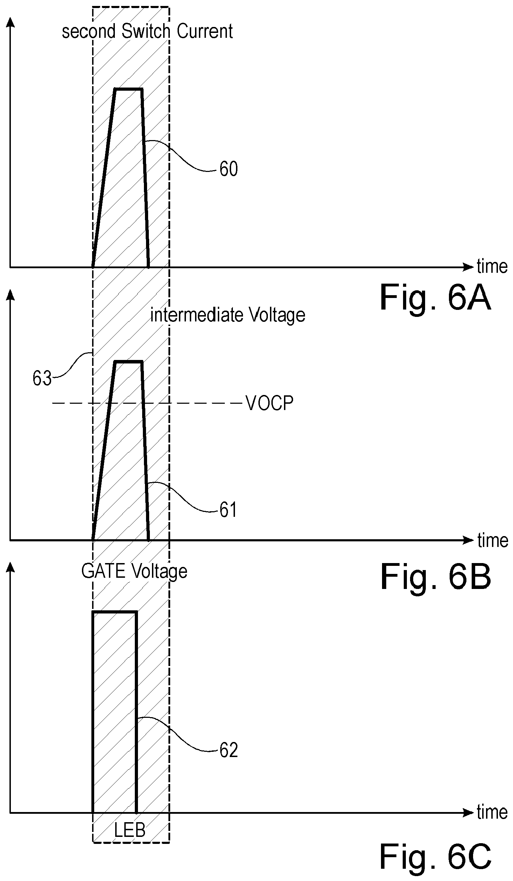

To further illustrate the operation of the method of Fig. 4 and the devices of Figs. 1 to 4, Fig. 5, including subfigures 5A to 5C, and Fig. 6, including subfigures 6A to 6C, show example signals. Fig. 5 shows signals where a case where no error is detected based on the intermediate voltage (no/yes at 42 in Fig. 4). A curve 50 in Fig. 5A shows a current through the second switch device, for example second switch device 12 of Fig. 1, source transistor 23 of Fig. 2 or source transistor 315 in Fig. 3.

A curve 51 in Fig. 5B shows an example for the on-resistances of the sources switch. A curve 52 in Fig. 5C shows a schematic example for a control voltage like a gate voltage applied to a gate terminal of the power switch device like power switch device 11 in Fig. 1, power transistor 22 of Fig. 2 and power switch 38 of Fig. 3. An area 53 designates the leading edge blanking time.

As can be seen, when switching on the power switch device using the gate voltage shown in Fig. 5C, the current through the second switch device (and therefore also through the power switch device, as they are coupled in series) exhibits a spike due to discharging of parasitic capacitances, as explained. As during this time the on-resistance of the second switch is at a higher value, this current is limited. Otherwise, the current rises until an off condition is reached, for example at the peak voltage the peak is reached at 46 at Fig. 4.

Fig. 6 shows example signals for a fault case. A curve 60 in Fig. 6A shows the source switch current, a curve 61 in Fig. 6B shows an intermediate voltage like voltage VI of Fig. 1, and a curve 62 in Fig. 6C shows a control voltage for the power switch device, for example gate voltage.. An area 63 indicates the leading edge blanking time. Here, for example due to a short circuit in a load, the current as indicated by curve 60 raises strongly. This leads to the intermediate voltage represented by curve 61 being above a threshold voltage VOCP for a predefined time. This in term (see 42 in Fig. 4) causes outputting a fault signal and turning off the primary switch device, corresponding to the control signal 62 being set to 0. In this way, damaging of components may be prevented.

By selecting the threshold voltage VOCP for Fig. 6B, 42 of Fig. 4 or Fig. 2 and the corresponding threshold time for example of timer 28, accordingly, embodiments discussed herein may ensure that the power switch device used remains within its so-called safe operating range, i.e. an operating range where damaging of the device is highly unlikely. As an example, a curve in Fig. 7 shows currents versus drain source voltages which may be supported for different times. A curve 70 illustrates example thresholds, for example operation current may be maintained below 1 A with voltages below 400 V to ensure safe operation. The values selected in a particular implementation then depend on the properties, in particular safe operating area, of the power switch device and second switch device used in a particular implementation. In the example shown, maintaining the current below 1A implies that the leading edge blanking time should not be more than 1µs.

Next, an implementation example for setting a first on-resistance and a second on-resistance for a second switch device like second switch device 12, source transistor 23 or source transistor 315 will be explained referring to Fig. 8.

Fig. 8 shows an implementation example for a multilevel driver like multilevel driver 24 of Fig. 2 or multilevel driver 316 of Fig. 3, driving a source transistor 81, which may be second switch device 12 of Fig. 1, source transistor 23 of Fig. 2 or source transistor 315 of Fig. 3. Multilevel gate driver 80 generates a reference gate voltage at a diode connected transistor 85 with a reference current IBIAS generated by a current source 83. Transistor 85 may be a scaled version of source transistor 81 scaled by a factor of 1/N. This reference gate voltage is provided via a switch 87 to a driver output stage 88 to control source transistor 81 to have a first, higher on-resistance. The on-resistance can be adjusted by setting current IBIAS.

Furthermore, via a switch 86 a voltage VDD generated by a voltage source 82 may be provided to source transistor 81 via a switch 86, thus biasing the gate of source transistor 81 to have a second on-resistance lower than the first on-resistance.

Switches 86, 87 may be implemented as transistor switches and are controlled via a signal VLEB. In the embodiment of Fig. 8, a signal VLEB directly controls switch 87 and controls switch 86 via an inverter 84. In embodiments, VLEB is at a state 1 indicating that switch 87 is to be closed during the leading edge blanking time and at a state 0 as otherwise, such that during the leading edge blanking time switch 87 is on and switch 86 is off, such that source transistor 81 has the first on-resistance, and otherwise, switch 86 is on and switch 87 is off, such that source switch 81 has the second, lower on-resistance. In this embodiment, source switch 81 is always switched on, either with the first on-resistance or the second on-resistance. In other embodiments, source switch 81 may be switched off (for example by disabling driver output stage 88) when the respective power switch device like power switch device 11 of Fig. 1, power transistor 22 of Fig. 2 or power transistor 38 of Fig. 3 is switched off. The signal VLEB may be generated based on the drive signal applied to the respective power switch device. For example, a leading edge of the gate signal supplied to power transistor 22 or 38 (for example signal 52 of Fig. 5C) may be filtered to obtain a signal which goes low together with the gate voltage going high, but rises to high again after the leading edge blanking time.

Fig. 9 illustrates a switch device 90 which may replace second switch device 12, for example in the embodiment of Fig. 1. Switch device 90 includes a first switch 91 and a second switch 92. Each of first switch 91 and second switch 92 may be implemented using a power transistor. First and second switches 91, 92 are coupled in parallel between a terminal 94 and a terminal 95. In use, for example terminal 94 may be coupled to a load like a primary winding of a transformer, and terminal 95 may be coupled to ground.

First switch 91 has a higher on-resistance RDSon1 than second switch 92, which has an on-resistances RDSon2. For example, assuming that a maximum allowable current is 1A, and a minimum threshold voltage of transistors used for switches 91, 92 is three volt and a maximum gate on voltage is ten volt, the on-resistance RDSon1 of first switch 91 may be designed to be 7 Q, while the on voltage RDSon2 of second switch 92 may be designed to be 0.2 Ω. This are merely examples, and depending on properties of switches 91, 92 and the application, other values may be used.

At a terminal 97, a pulse width modulated signal PWM is provided, which corresponds to the pulse width modulated signal discussed above for controlling a power switch. The pulse width modulated signal directly controls first switch 91. Therefore, when the switch device 90 is to be switched on based on the pulse width modulated signal PWM (meaning that in the embodiment of Fig 1 where switch device 90 is used as second switch device 12, also power switch device 11, for example, is switched on), first switch 91 is switched on all the time. Switch device 90 receives the already discussed signal VLEB at a terminal 96. VLEB as explained is low during the leading edge blanking time and high otherwise, as explained above. Signal VLEB is provided to an input of an AND gate 93, and signal PWM is provided to the other input of AND gate 93. By this logic, second switch 92 is switched on outside of the leading edge blanking time when signal PWM indicates that switch device 90 is to be switched on. In other words, during the leading edge blanking time only first switch 91 is switched on resulting in a higher on-resistance, and after the leading edge blanking time, both switches 91, 92 are switched on, leading to a lower on-resistance. Therefore, a current through a spike is shown in Fig. 5A is limited by the higher on-resistance.

While in the embodiments above mainly monitoring during the leading edge blanking time has been discussed, the circuit of Fig. 10 also provides essentially conventional overcurrent monitoring during outside the leading edge blanking time.

The circuit of Fig. 10 receives, as inputs, the pulse width modulated control signal PWM (via an inverter 1010) and the signal VLEB discussed earlier.

Furthermore, the circuit of Fig. 10 receives a voltage VCSPEAK which is a voltage indicative of a peak primary current through the switch devices used, for example primary current through load 13, power switch device 11 and second switch device 12 of Fig. 1. VCSPEAK is sampled at the rising edge of VLEB during the leading edge blanking time, i.e. only at the end of the leading edge blanking time, as explained below, and continuously after the leading edge blanking time.

The circuit of Fig. 10 comprises a first comparator 1004 and a second comparator 1005. First comparator 1004 compares the voltage VCSPEAK with a voltage VOCP_nom generated by a voltage source 1001 for monitoring the current outside the leading edge blanking time. An output of first comparator 104 is provided to a first input of an AND gate 1007, and VLEB is provided to a second input of AND gate 1007. Therefore, a logic 1 output by comparator 1004 indicative of a fault condition (VCSPEAK exceeding VOCP nom) is only forwarded to an OR gate 1008 outside the leading edge blanking time.

Furthermore, VCSPEAK is compared to a threshold voltage VDCP_LEB generated by a voltage source 1003. VDCP_LEB is a threshold value for monitoring during the leading edge blanking time. An output of comparator 1005 is sampled by a latch 1006 clocked by VLEB, such that the output is sampled only during at the rising edge of VLED as mentioned above. An output of latch 1006 is provided also to OR gate 1008. Therefore, if either latch 1006 or AND gate 1007 outputs a logic 1 (see above), a fault is indicted by the circuit of Fig. 10. In this way, monitoring both during the leading edge blanking time or afterwards is achieved. Ledge 1006 is reset by an inverted signal PWM, such that it is reset after each switching cycle.

Simulation results have shown that by using a higher on-resistance during the leading edge blanking time, for examples spikes due to discharging of parasitic capacitances, may be limited.

Some embodiments are defined by the following examples:
Example 1. A switch controller comprising:
   a driver configured to drive a power switch device and a second switch device coupled in series to the power switch, wherein the driver is configured to, when switching on the power switch device, set the second switch device to a first on-resistance for a predefined time starting from switching on the power switch device, and after the predefined time, set the second switch device to a second on-resistance lower than the first on-resistance.
Example 2. The switch controller of example 1, wherein the first on-resistance is greater than 2 Q, and the second on-resistance is smaller than 1 Q.
Example 3. The switch controller of example 1 or 2, wherein the predefined time is at least 100 ns.
Example 4. The switch controller of any one of examples 1 to 3, wherein the driver is configured to set the second switch device to the first on-resistance by applying a first control voltage to the second switch device, and to set the second switch device to the second on-resistance by applying a second control voltage to the second switch device different from the first control voltage.
Example 5. The switch controller of any one of examples 1 to 4, further comprising the second switch device.
Example 6. The switch controller of any one of examples 1 to 5, wherein the switch controller further comprises an overcurrent detection circuit configured to detect a fault condition based on a voltage between the first switch device and the second switch device at least during the predefined time.
Example 7. The switch controller of any one of examples 1 to 6, wherein the second switch device comprises a first switch coupled in parallel to a second switch, wherein the first switch has a higher on-resistance than the second switch, wherein, when switching the switch device on, the driver is configured to switch on only the first switch during the predefined time and switch on both the first switch and the second switch after the predefined time.
Example 8. The switch controller of any one of examples 1 to 7, wherein the switch controller is configured to compare an indication of a peak current through the switch device to a first threshold during the predefined time and to a second threshold after the predefined time to detect a fault condition.
Example 9. The switch controller of any one of examples 1 to 8, wherein the switch controller is configured to switch the switch device on and off based on a pulse width modulated control signal.
Example 10. A device, comprising: the switch controller of any one of examples 1 to 9, and the power switch device.
Example 11. The device of example 10, wherein the device is a power converter, and wherein the switch controller is configured to control the power switch device to selectively provide power to a primary winding of a transformer, wherein a secondary winding of the transformer is coupled to an output of the power converter.
Example 12. A method, comprising:
   switching on a power switch device; and
   controlling a second switch device coupled in series to the power switch device to have a first on-resistance for a predefined time after switching on the power switch device, and to have a second on-resistance lower than the first on-resistance after the predefined time.
Example 13. The method of example 12, wherein the first on-resistance is greater than 2 Q, and the second on-resistance is smaller than 1 Ω.
Example 14. The method of example 12 or 13, wherein the predefined time is at least 100 ns.
Example 15. The method of any one of examples 12 to 14, wherein
   setting the second switch device to the first on-resistance comprises applying a first control voltage to the second switch device, and setting the second switch device to the second on-resistance comprises applying a second control voltage to the second switch device different from the first control voltage, and/or
   setting the second switch device to the first on-resistance comprises switching on only a first switch of the second switch device, and setting the second switch device to the second on-resistance comprises switching on both the first switch and a second switch coupled in parallel to the first switch the second switch device.
Example 16. The method of any one of examples 12 to 15, wherein controlling the second switch device to have the first on-resistance comprises applying a first control voltage to the second switch device, and controlling the second switch device to have the second on-resistance comprises applying a second control voltage to the second switch device different from the first control voltage.
Example 17. The method of any one of examples 12 to 16, further comprising comparing an indication of a peak current through the switch device to a first threshold during the predefined time and to a second threshold after the predefined time to detect a fault condition.
Example 18. The method of any one of examples 12 to 17, further comprising detecting a fault condition based on a voltage between the first switch device and the second switch device at least during the predefined time.
Example 19. The method of any one of examples 12 to 18, further comprising controlling the power switch device to selectively provide power to a primary winding of a transformer of a power converter, wherein a secondary winding of the transformer is coupled to an output of the power converter.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A switch controller (39) comprising:
a driver (14; 312) configured to drive a power switch device (11; 22; 38) and a second switch device (12; 23; 315; 81; 91, 92) coupled in series to the power switch, wherein the driver (14; 312) is configured to, when switching on the power switch device (11; 22; 38), set the second switch device (12; 23; 315; 81) to a first on-resistance for a predefined time starting from switching on the power switch device (11; 22; 38), and after the predefined time, set the second switch device(12; 23; 315; 81; 91, 92) to a second on-resistance lower than the first on-resistance.

2. The switch controller (39) of claim 1, wherein the first on-resistance is greater than 2 Q, and the second on-resistance is smaller than 1 Ω.

3. The switch controller (39) of claim 1 or 2, wherein the predefined time is at least 100 ns.

4. The switch controller (39) of any one of claims 1 to 3, wherein the driver (14; 312) is configured to set the second switch device (12; 23; 315; 81) to the first on-resistance by applying a first control voltage to the second switch device (12; 23; 315; 81), and to set the second switch device (12; 23; 315; 81) to the second on-resistance by applying a second control voltage to the second switch device (12; 23; 315; 81) different from the first control voltage.

5. The switch controller (39) of any one of claims 1 to 4, further comprising the second switch device (12; 23; 315; 81) .

6. The switch controller (39) of any one of claims 1 to 5, wherein the switch controller (39) further comprises an overcurrent detection circuit configured to detect a fault condition based on a voltage (VI) between the first switch device and the second switch device (12; 23; 315; 81) at least during the predefined time.

7. The switch controller (39) of any one of claims 1 to 6, wherein the second switch device (12; 23; 315; 81; 91, 92) comprises a first switch (91) coupled in parallel to a second switch (92), wherein the first switch (91) has a higher on-resistance than the second switch (92), wherein, when switching the switch device (11, 12; 22, 23; 38; 315; 81; 91, 92) on, the driver (14; 312) is configured to switch on only the first switch (91) during the predefined time and switch on both the first switch (91) and the second switch (92) after the predefined time.

8. The switch controller (39) of any one of claims 1 to 7, wherein the switch controller is configured to compare an indication of a peak current through the switch device (11, 12; 22, 23; 38; 315; 81; 91, 92) to a first threshold during the predefined time and to a second threshold after the predefined time to detect a fault condition.

9. The switch controller (39) of any one of claims 1 to 8, wherein the switch controller is configured to switch the switch device on and off based on a pulse width modulated control signal (PWM).

10. A device, comprising:
the switch controller (39) of any one of claims 1 to 9, and
the power switch device (11; 22; 38).

11. The device of claim 10, wherein the device is a power converter, and wherein the switch controller is configured to control the power switch device (11; 22, 23; 38; 315; 81; 91, 92) to selectively provide power to a primary winding of a transformer (21; 35), wherein a secondary winding of the transformer is coupled to an output of the power converter.

12. A method, comprising:
switching on a power switch device (11; 22; 38); and
controlling a second switch device (12; 23; 315; 81; 91, 92) coupled in series to the power switch device (11; 22; 38) to have a first on-resistance for a predefined time after switching on the power switch device (11, 12; 22, 23; 38; 315; 81; 91, 92), and to have a second on-resistance lower than the first on-resistance after the predefined time.

13. The method of claim 12, wherein the first on-resistance is greater than 2 Q, and the second on-resistance is smaller than 1 Ω.

14. The method of claim 12 or 13, wherein the predefined time is at least 100 ns.

15. The method of any one of claims 12 to 14, wherein
setting the second switch device (12; 23; 315; 81) to the first on-resistance comprises applying a first control voltage to the second switch device (12; 23; 315; 81), and setting the second switch device (12; 23; 315; 81) to the second on-resistance comprises applying a second control voltage to the second switch device (12; 23; 315; 81) different from the first control voltage, and/or
setting the second switch device (12; 23; 315; 81) to the first on-resistance comprises switching on only a first switch (91) of the second switch device (12; 23; 315; 81), and setting the second switch device (12; 23; 315; 81) to the second on-resistance comprises switching on both the first switch (91) and a second switch (92) coupled in parallel to the first switch (91) the second switch device (12; 23; 315; 81).
